# EUROPÄISCHE PATENTANMELDUNG

(11) **EP 1 164 631 A2**
(43) Veröffentlichungstag der Anmeldung: **19.12.2001**
(21) Anmeldenummer: 01114346.8
(22) Anmeldetag: 13.06.2001
(51) Int. Cl.: H01L 21/3105, H01L 21/311, H01L 21/02, H01L 21/8246, H01L 27/115

(54) **Verfahren zur Erzeugung von Öffnungen in einer Schicht**

(30) Priorität: 14.06.2000 DE 10029290
(71) Anmelder: Infineon Technologies AG, 81669 München (DE)
(72) Erfinder: Kroenke, Matthias, 01099 Dresden (DE); Schindler, Günther, 80802 München (DE)
(74) Vertreter: Graf Lambsdorff, Matthias, Dr.

(57) **Zusammenfassung**

Die Erfindung betrifft ein Verfahren zur gezielten lokalen Erzeugung von Öffnungen in einer Schicht (15), insbesondere an mikroelektronischen Strukturen, wobei auf ein Substrat (1, 5, 7, 9) eine erhabene Hilfsstruktur (11) aufgebracht wird, so dass sie einen Teil der Oberfläche des Substrats (1, 5, 7, 9) bedeckt, die zu öffnende Schicht (15) auf die Hilfsstruktur (11) aufgebracht wird und durch planares Ätzen Material der Schicht (15) und ggf. weiteres Material (17) entfernt wird bis die Schicht (15) an der Hilfsstruktur (11) geöffnet wird und das Hilfsmaterial (13) freigelegt wird.

## Beschreibung

Die Erfindung betrifft ein Verfahren zur gezielten lokalen Erzeugung von Öffnungen in einer Schicht, insbesondere einer Schutzschicht an mikroelektronischen Strukturen. Die Erfindung betrifft insbesondere ein Verfahren zur Herstellung einer nicht flüchtigen Speicherzelle zur Speicherung von binären Daten. Derartige Speicherzellen weisen üblicherweise einen Schalttransistor und einen Speicherkondensator auf. Die Kondensatorelektroden können ein Platinmetall enthalten, zwischen denen ein ferroelektrisches oder paraelektrisches Material als Dielektrikum angeordnet ist.

Konventionelle mikroelektronische Halbleiterspeicher-Bauelemente (DRAMs) bestehen im wesentlichen aus einem Auswahl- oder Schalttransistor und einem Speicherkondensator, in welchem zwischen zwei Kondensatorplatten ein dielektrisches Material eingefügt ist. Als Dielektrikum werden üblicherweise zumeist Oxid- oder Nitridschichten verwendet, die eine Dielektrizitätszahl von maximal etwa 8 aufweisen. Zur Verkleinerung des Speicherkondensators sowie zur Herstellung von nicht-flüchtigen Speichern werden "neuartige" Kondensatormaterialien (Ferroelektrika oder Paraelektrika) mit deutlich höheren Dielektrizitätszahlen benötigt. Beispiele für solche Materialien sind in der Publikation "Neue Dielektrika für Gbit-Speicherchips" von W. Hönlein, Phys. B1. 55 (1999), genannt. Zur Herstellung von ferroelektrischen Kondensatoren zum Einsatz in nicht-flüchtigen Halbleiterspeicher-Bauelementen hoher Integrationsdichte können z.B. ferroelektrische Materialien, wie SrBi₂(Ta,Nb)₂O₉ (SBT oder SBTN), Pb(Zr, Ti)O₃ (PZT), oder Bi₄Ti₃O₁₂ (BTO) als Dielektrikum zwischen den Kondensatorplatten eingesetzt werden. Es kann aber auch ein paraelektrisches Material, wie beispielsweise (Ba,Sr)TiO₃ (BST), zum Einsatz kommen.

Die Verwendung dieser neuartigen Dielektrika, stellt jedoch die Halbleiterprozesstechnologie vor neue Herausforderungen. Zunächst lassen sich diese neuartigen Materialien nämlich nicht mehr mit dem traditionellen Elektrodenmaterial polykristallines Silizium kombinieren. Deshalb müssen inerte Elektrodenmaterialien, wie beispielsweise Platinmetalle oder deren leitfähige Oxide (z.B. RuO₂), eingesetzt werden. Der Grund hierfür liegt darin, dass nach dem Abscheiden des Ferroelektrikums dieses in einer sauerstoffhaltigen Atmosphäre bei Temperaturen von etwa 550-800°C gegebenenfalls mehrfach getempert ("konditioniert") werden muß. Zur Vermeidung von unerwünschten chemischen Reaktionen des Ferroelektrikums mit den Elektroden werden diese daher zumeist aus Platin oder einem anderen ausreichend temperaturstabilen und inerten Material, wie einem anderen Platinmetall (Pd, Ir, Rh, Ru, Os), gefertigt.

Zur Integration der Speicherkondensatoren werden Prozeßschritte ausgeführt, die in wasserstoffhaltiger Umgebung stattfinden. So ist beispielsweise zur Konditionierung der Metallisierung und der Transistoren eine Temperung in Formiergas notwendig, welches zu 95 % aus Stickstoff (N₂) und zu 5 % aus Wasserstoff (H₂) zusammengesetzt ist. Das Eindringen von Wasserstoff in den prozessierten Speicherkondensator, d.h. in das Dielektrikum, kann jedoch durch Reduktionsreaktionen zu einer Degradation der oxidischen Keramiken des Dielektrikums führen. Des weiteren können die plasmaunterstützte Abscheidung von Intermetalloxiden (PECVD) bzw. der Siliziumnitrid-Passivierungsschicht aufgrund des hohen Wasserstoffgehalts in den Schichten eine Reduktion des ferro-bzw. paraelektrischen Materials des Dielektrikums bewirken. Auch bei der Abscheidung von elektrisch leitfähigen Materialien, etwa Refraktärmetallen wie Wolfram oder Titan, wird Wasserstoff verwendet. Die Abscheidung dient beispielsweise der Erzeugung von Schichten oder dem Auffüllen von Kontaktlöchern.

Um die Kondensatoren beziehungsweise deren Dielektrika gegen Wasserstoff zu schützen, wird vorgeschlagen, eine Schutzschicht als Barriere gegen das Eindringen von Wasserstoff in den Kondensator vorzusehen. Die Schutzschicht besteht beispielsweise aus oxidischen Materialien wie Al₂O₃, ZrO₂ oder TiON und wird beispielsweise unmittelbar auf die Kondensatorstruktur aufgebracht.

Es ist üblich zur elektrischen Kontaktierung mikroelektronischer Baustrukturen, nach der Herstellung der eigentlichen Struktur und gegebenenfalls nach dem Aufbringen weiterer Materialien auf die Struktur, Kontaktlöcher zu ätzen und diese mit elektrisch leitfähigem Material aufzufüllen. Wird die elektrische Kontaktierung von der Seite aus vorgenommen, an der die Schutzschicht liegt, muß diese geöffnet werden.

Es ist bekannt, Kontaktlöcher nach dem RIE-Verfahren (Reactive Ion Etching) zu schaffen. Das RIE gehört zu den chemisch-physikalischen Trockenätzverfahren. Um die Öffnungen gezielt erzeugen zu können, werden dabei Resist-Masken verwendet. Zwar kann auf diese Weise mit hoher lokaler Präzision geätzt werden, jedoch sind die Ätzraten insbesondere bei Al₂O₃ und ZrO₂ niedrig. Beim Kontaktlochätzen nach bekannten Verfahren wie RIE wird das Problem dadurch verschärft, dass das Kontaktloch zunächst durch üblicherweise über der Schutzschicht liegendes Material (meist SiO₂) geätzt werden muß. Nach entsprechendem Ätzfortschritt wird dann die Schutzschicht erreicht. Das Ätzen eines ohnehin nur schwierig zu ätzenden Materials am Boden eines Lochs, hier des oberen Teils des Kontaktlochs, ist aber besonders schwierig, d.h. besonders langsam und häufig unpräzise.

Weiterhin ist die Selektivität zwischen unterschiedlichen Materialien gering, d.h. das Verfahren führt in der Regel auch zu einem Abtrag des Materials der Resist-Masken und/oder zu einem Abtrag von Elektrodenmaterial am Kontaktlochboden. Bei schrägem Einfall der Ionen auf die zu ätzende Oberfläche, das heißt wenn die Ionen nicht senkrecht auf die Oberfläche auftreffen, kann es zu Reflexionen an schrägen Ätzflanken kommen. Dies führt zur Bildung von unerwünschten Gräben oder Löchern seitlich am Rand der Ätzflanken oder am Boden des geätzten Lochs (sog. Trench-Effekt). Weiterhin kann das Auftreffen der Ionen, die beim RIE eine hohe kinetische Energie besitzen, zur Schädigung der zu ätzenden Oberfläche führen. Schließlich kommt es beim RIE zu sogenannten Redepositionen, d. h. abgetragenes Material schlägt sich andernorts nieder.

Insbesondere wenn es, wie bei den oben genannten Schutzschichten als Barrieren gegen das Eindringen von Wasserstoff, auf die Integrität der zu öffnenden Schicht ankommt, können die beschriebenen Effekte sich nachteilig auf die Funktion der Schicht bzw. auf die Funktion der mikroelektronischen Struktur auswirken. Beispielsweise können seitliche Gräben am Boden der geätzten Öffnung später zum Unterwandern der Wasserstoffbarriere mit Wasserstoffmolekülen führen.

Aufgabe der vorliegenden Erfindung ist es, ein Verfahren der eingangs genannten Art anzugeben, mit dem eine gezielte lokale Öffnung der zu öffnenden Schicht möglich ist, wobei die zu öffnende Schicht außerhalb des Bereichs der Öffnung möglichst unversehrt bleiben soll.

Die Aufgabe wird durch ein Verfahren mit den Merkmalen des Patentanspruchs 1 gelöst. Weiterbildungen sind Gegenstand der abhängigen Ansprüche.

Nach dem erfindungsgemäßen Verfahren wird auf ein Substrat, gegebenenfalls mit daran befindlichen Strukturen, insbesondere mikroelektronischen Strukturen, zumindest eine erhabene Hilfsstruktur aus einem Hilfsmaterial aufgebracht, so dass die Hilfsstruktur einen Teil der Oberfläche des Substrats bedeckt. Unter Substrat wird hier also die Einheit des eigentlichen Substrats, auf dem eine mikroelektronische Struktur aufgebracht ist, und der Struktur verstanden. Es können weitere Schichten oder Komponenten vorhanden sein, die dem Substrat zugerechnet werden.

Auf die Hilfsstruktur wird die zu öffnende Schicht aufgebracht, so dass sie einen zusammenhängenden Oberflächenbereich des Substrats und der Hilfsstruktur bedeckt. Danach wird durch im wesentlichen planares Ätzen Material der Schicht und gegebenenfalls weiteres an der Oberfläche liegendes Material entfernt bis die Schicht an der Hilfsstruktur geöffnet wird und das Hilfsmaterial freigelegt wird.

Unter planarem Ätzen werden Ätzverfahren verstanden, die Material an einer ebenen Oberfläche etwa gleichmäßig abtragen bzw. Material an einer Oberfläche derart abtragen, dass eine im wesentlichen ebene Oberfläche entsteht. Durch das planare Ätzen wird also gerade das an der erhabenen Hilfsstruktur befindliche Material der Schicht entfernt und das Material der Hilfsstruktur (Hilfsmaterial) freigelegt. Dagegen bleibt Hilfsmaterial außerhalb des erhabenen Oberflächenbereichs unberührt.

Ein wesentlicher Vorteil der Erfindung besteht darin, dass unerwünschte Nebeneffekte beim Öffnen der Schicht, wie der Trench-Effekt und Redepositionen, nicht eintreten. Weiterhin entsteht ein scharfer, genau definierter Übergang zwischen der zu öffnenden Schicht und dem Material der Hilfsstruktur. Die Maße bzw. die Lage des Übergangs sind definiert durch die Gestaltung der Hilfsstruktur und der Schicht und durch den Fortschritt des planaren Ätzens. Die Größe der Öffnung in der Schicht kann jedoch auch unabhängig vom Fortschritt des planaren Ätzens sein, nämlich wenn die Schicht am Rand der erhabenen Hilfsstruktur sich in eine Richtung erstreckt, die senkrecht zur Ätzebene verläuft. In diesem Fall muß lediglich das auf der Erhebung der Hilfsstruktur befindliche Material abgetragen werden, das sich insbesondere parallel zur Ätzebene erstreckt.

Die erhabene Hilfsstruktur ist insbesondere eine inselartige Erhebung. In diesem Fall wird das Material der Schicht derart entfernt, dass es einen geschlossen umlaufenden Rand um das freigelegte Hilfsmaterial bildet. Diese Ausgestaltung des Verfahrens kann vor allem dann nutzbringend angewendet werden, wenn durch die zu öffnende Schicht hindurch eine elektrische Kontaktierung vorgenommen werden soll.

Bei einer Weiterbildung des Verfahrens wird nach dem Aufbringen der zu öffnenden Schicht ein zweites Hilfsmaterial aufgebracht, so dass Unebenheiten zumindest teilweise ausgeglichen werden bzw. tieferliegende Bereiche zumindest teilweise aufgefüllt werden. Vorzugsweise wird die Ätzebene beim planaren Ätzen etwa parallel zu dem Verlauf der Oberfläche des zweiten Hilfsmaterials eingestellt. Das zweite Hilfsmaterial, das aus dem gleichen Stoff oder einem anderen Stoff wie das Hilfsmaterial der Hilfsstruktur bestehen kann, dient der mechanischen Stabilisierung der gesamten Struktur, insbesondere der zu öffnenden Schicht. Es ist somit gewährleistet, dass der Materialabtrag allein durch die Prozeßführung des planaren Ätzens gesteuert wird. Auch schützt das zweite Hilfsmaterial das Material der Schicht, welches außerhalb des zu öffnenden Bereichs liegt, dauerhaft gegen äußere Einflüsse.

Das erste und/oder zweite Hilfsmaterial ist insbesondere ein oxidisches Material, etwa SiO₂. Es kann aber auch jedes andere geeignete Material verwendet werden. Soll durch das erste und/oder zweite Hilfsmaterial eine elektrische Isolation erzielt werden, können beliebige dielektrische Materialien zum Einsatz kommen, z.B. auch Polymere wie PTFE (Polytetrafluorethylen). Diese zeichnen sich durch zum Teil besonders hohe Dielektrizitätszahlen aus.

Bevorzugtermaßen wird das planare Ätzen zumindest teilweise durch CMP (chemisch-mechanisches Polieren) ausgeführt. Bei diesem an sich bekannten Verfahren, das als Planarisierungsverfahren bekannt ist, kann das Gewicht der Verfahrenskomponenten zwischen einem chemisch unterstützten mechanischen Polieren und einem durch mechanische Einwirkung unterstützten chemischen Nassätzen je nach Bedarf verschoben werden. Üblicherweise wird beim CMP ein Poliertisch mit einer elastischen Auflage (Pad) vorgesehen, auf die wiederum ein Poliermittel (Slurry) aufgebracht ist. Die zu ätzende Oberfläche wird auf das Pad gedrückt, so dass eine Relativbewegung zwischen der Oberfläche und dem Pad stattfindet. Dabei können der Poliertisch und/oder die zu ätzende Oberfläche rotieren.

Das Slurry wird vorzugsweise unter Berücksichtigung der jeweiligen Eigenschaften des abzutragenden Materials ausgewählt, wobei meist ein möglichst großer Ätzfortschritt erreicht werden soll.

Bei der Ausgestaltung des Verfahrens, bei dem das oben beschriebene zweite Hilfsmaterial aufgebracht wird, so dass eine im wesentlichen ebene Oberfläche entsteht, wird bevorzugtermaßen zunächst ein im Hinblick auf das zweite Hilfsmaterial optimiertes Slurry verwendet und nach entsprechendem Ätzfortschritt auf ein im Hinblick auf das Material der zu öffnenden Schicht optimiertes Slurry übergegangen. Dabei kann, sofern dies erwünscht ist, auch eine selektiv höhere Ätzrate an dem Material der zu öffnenden Schicht erreicht werden.

Bei einer Weiterbildung des Verfahrens wird in das freiliegende Hilfsmaterial der Hilfsstruktur eine Ausnehmung geätzt, die insbesondere der elektrischen Kontaktierung durch die geöffnete Schicht hindurch dient. Vorzugsweise entsteht dabei ein geschlossen umlaufender Rand, der durch das Hilfsmaterial er Hilfsstruktur gebildet wird. Somit ist die Ausnehmung von dem Material der zu öffnenden Schicht beabstandet. Dies hat den Vorteil, dass die geöffnete Schicht mechanisch stabilisiert ist. Weiterhin können die bekannten Verfahren zum Erzeugen von Kontaktlöchern und dergleichen Ausnehmungen angewendet werden, etwa das zuvor beschriebene RIE. Das Hilfsmaterial der Hilfsstruktur schützt die geöffnete Schicht und verhindert, dass unerwünschte Abtragungen des Schichtmaterials stattfinden. In die insbesondere bis zu einem elektrisch leitfähigen Material reichende Ausnehmung kann ein weiteres elektrisch leitfähiges Material eingebracht werden. Die Ausnehmung kann auch bis zu einer gegenüberliegenden Außenseite des Substrats vorangetrieben werden und erst nach dem Auffüllen der Ausnehmung mit elektrisch leitfähigem Material eine weitere elektrische Kontaktierung vorgenommen werden.

Mit besonderem Vorteil wird das erfindungsgemäße Verfahren bei Substraten eingesetzt, die eine mikroelektronische Struktur mit einem Kondensator aufweisen, dessen Dielektrikum ein ferroelektrisches oder paraelektrisches Material aufweist. Hierbei stellt die zu öffnende Schicht insbesondere eine Barriere gegen Eindringen einer Substanz in die mikroelektronische Struktur dar. Beispielsweise ist das Dielektrikum empfindlich gegen das Eindringen von Wasserstoff oder gegen den Kontakt mit Wasserstoff und bildet die zu öffnende Schicht eine Barriere gegen das Eindringen von Wasserstoff in die mikroelektronische Struktur, insbesondere im Bereich des Dielektrikums.

Bei dieser Ausgestaltung kommt es besonders auf die Unversehrtheit auf der zu öffnenden Schicht außerhalb des zu öffnenden Bereichs an. Im Zuge der fortschreitenden Miniaturisierung von digitalen Speicherbausteinen kommt es entscheidend auf handhabbare Verfahrenstechniken an, die eine gezielte, präzise Erzeugung solcher Strukturen erlauben und die dauerhafte Funktionsfähigkeit der Strukturen nicht gefährden. Die Erfindung stellt somit ein Verfahren bereit, das die Herstellung von Öffnungen präzise ermöglicht, obwohl oder gerade deshalb, weil es einen planaren Abtrag von Material ermöglicht. Die Lage der Öffnung wird nämlich bereits vorher durch die Gestaltung der Hilfsstruktur festgelegt oder zumindest mitbestimmt. Die Gestaltung der Hilfsstruktur ist mit bekannten Verfahrenstechniken bei hoher Präzision möglich. Es kommen beispielsweise bekannte Trockenätzverfahren wie RIE zum Einsatz. Eine Beschädigung der später zu öffnenden Schicht ist ausgeschlossen, da die Schicht bei der Strukturierung der Hilfsstruktur noch gar nicht vorhanden ist.

Die Erfindung wird nun anhand eines Ausführungsbeispiels näher erläutert. Dabei wird Bezug auf die beigefügte Zeichnung genommen. Die Erfindung ist jedoch nicht auf dieses Ausführungsbeispiel beschränkt. Die einzelnen Figuren der Zeichnung zeigen:
- Fig. 1: ein Substrat mit zwei erhabenen inselartigen Hilfsstrukturen, wobei die Oberfläche des Substrats und der Hilfsstrukturen mit einer zu öffnenden Schicht überzogen ist;
- Fig. 2: den Aufbau nach Fig. 1, nachdem ein zweites Hilfsmaterial aufgebracht wurde, das eine im wesentlichen ebene Oberfläche bildet;
- Fig. 3: den Aufbau nach Fig. 2, nachdem durch planares Ätzen Öffnungen in der zu öffnenden Schicht erzeugt wurden; und
- Fig. 4: den Aufbau nach Fig. 3, nachdem Löcher zum elektrischen Kontaktieren der mikroelektronischen Struktur erzeugt wurden.

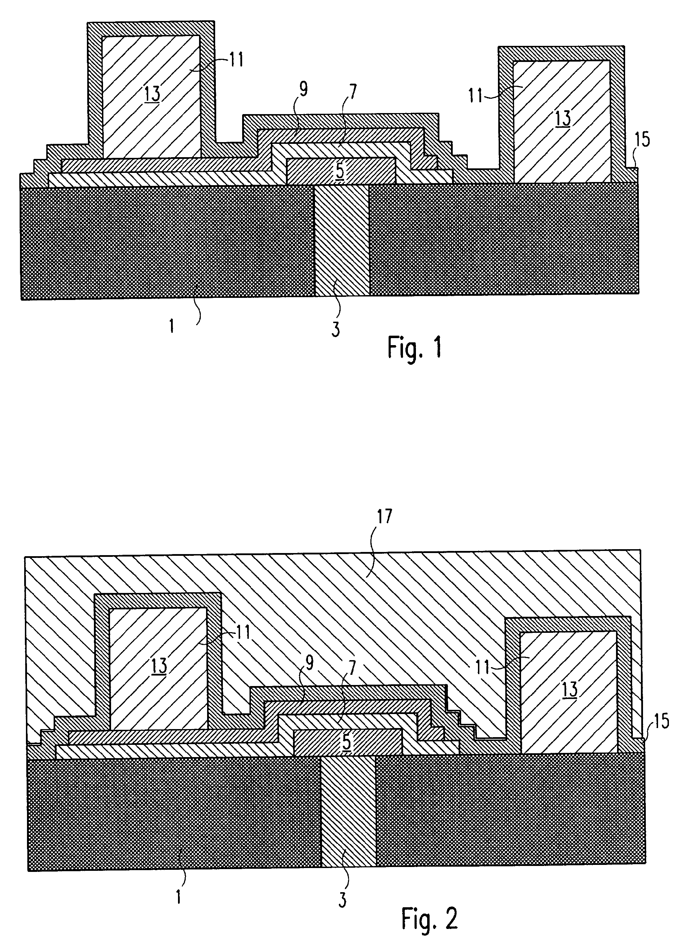

Der in Fig. 1 gezeigte Aufbau weist ein Trägermaterial 1 auf, wie es in der Fertigung von Halbleiterbauteilen üblicherweise Verwendung findet, beispielsweise kristallines Silizium. In dem Trägermaterial 1 ist eine elektrische Verbindung 3 zur elektrischen Kontaktierung und Verbindung mikroelektronischer Strukturen eingebracht. Die elektrische Verbindung 3 kontaktiert eine erste Elektrode 5 aus einem elektrisch leitfähigen Material, insbesondere aus einem inerten Material wie Platinmetall (Pt, Pd, Ir, Rh, Ru, Os).

Auf die erste Elektrode 5 ist ein Dielektrikum 7 aus einem ferroelektrischen oder paraelektrischen Material aufgebracht. Das Dielektrikummaterial ist insbesondere empfindlich gegen den Kontakt und/oder das Eindringen von Wasserstoff.

Auf das Dielektrikum 7 ist eine zweite Elektrode 9 aufgebracht, die insbesondere aus dem gleichen Material wie die erste Elektrode 5 besteht. Die beiden Elektroden 5, 9 und das Dielektrikum 7 bilden zusammen einen Kondensator zur Speicherung digitaler Information. Der Kondensator kann in bekannter Weise mit einem Auswahl- oder Schalttransistor zu einem Speicherelement (DRAM) kombiniert sein. Der Transistor befindet sich insbesondere in oder unterhalb des Trägermaterials 1 und ist vorzugsweise über die elektrische Verbindung 3 mit der ersten Elektrode 5 elektrisch verbunden (nicht dargestellt).

Wie in Fig. 1 dargestellt, ist im linken Endbereich der zweiten Elektrode 9 eine Insel 11 aus einem Hilfsmaterial 13 aufgebracht. Eine weitere Insel 11 aus dem Hilfsmaterial 13 ist unmittelbar auf die Oberfläche des Trägermaterials 1 aufgebracht. Das Hilfsmaterial 13 ist insbesondere ein oxidisches Hilfsmaterial, etwa SiO₂. Das Hilfsmaterial 13 kann in bekannter Weise als durchgehende etwa gleichmäßig hohe Schicht auf der Oberfläche des Substrats 1, 5, 7, 9 abgeschieden werden und es kann dann anschließend in ebenfalls bekannter Weise, beispielsweise unter Verwendung von Masken, die in Fig. 1 dargestellte inselartige Struktur geätzt werden.

Bei dem anhand von Fig. 1 bis Fig. 4 beschriebenen Ausführungsbeispiel ist darauf zu achten, dass die Inseln 11 sich über das Niveau des Kondensators 5, 7, 9 erheben.

Nach Strukturierung der Inseln 11 wird die zu öffnende Schutzschicht 15 aufgebracht, so dass die gemeinsame Oberfläche des Trägermaterials 1 des Kondensators 5, 7, 9 und der Inseln 11 einseitig durchgehend mit dem Material der Schutzschicht 15 bedeckt ist. Das Material der Schicht ist beispielsweise ein oxidisches Material wie Al₂O₃, ZrO₂ oder TiON. Die Schutzschicht 15 besteht aus einem geeigneten Material und weist eine ausreichende Dicke auf, um ein Hindurchtreten von Wasserstoff zu verhindern. Die Schutzschicht 15 ist somit eine Barriere gegen das Hindurchtreten von Wasserstoff und schützt das gegen Wasserstoff empfindliche Dielektrikum 7. In horizontaler Richtung (Fig. 1) verläuft die Schutzschicht 15 vom Rand der Inseln 11 aus gesehen entlang der zweiten Elektrode 9 beziehungsweise entlang der Oberfläche des Trägermaterials 1. Selbst wenn sich Hohlräume am Materialübergang zwischen der zweiten Elektrode 9 und der Schutzschicht 15 beziehungsweise zwischen dem Trägermaterial 1 und der Schutzschicht 15 befinden sollten, stellt die beschriebene Anordnung eine wirksame Barriere gegen das Eindringen von Wasserstoff in den Kondensator 5, 7, 9 dar, selbst wenn der Wasserstoff in das Gebiet der Inseln 11 eindringen sollte. Hierfür ist hilfreich, dass bei dem Ausführungsbeispiel auch die zweite Elektrode 9 und das Trägermaterial 1 eine wirksame Barriere gegen das Hindurchtreten von Wasserstoff darstellen.

Wie aus Fig. 2 ersichtlich wird auf den in Fig. 1 gezeigten Aufbau ein zweites Hilfsmaterial, nämlich eine Oxidschicht 17 aufgebracht, die beispielsweise aus SiO₂ besteht. Die Oxidschicht 17 ebnet die durch die Inseln 11 und den Kondensator 5, 7, 9 verursachten Unebenheiten ein und bildet eine im wesentlichen ebene Oberfläche.

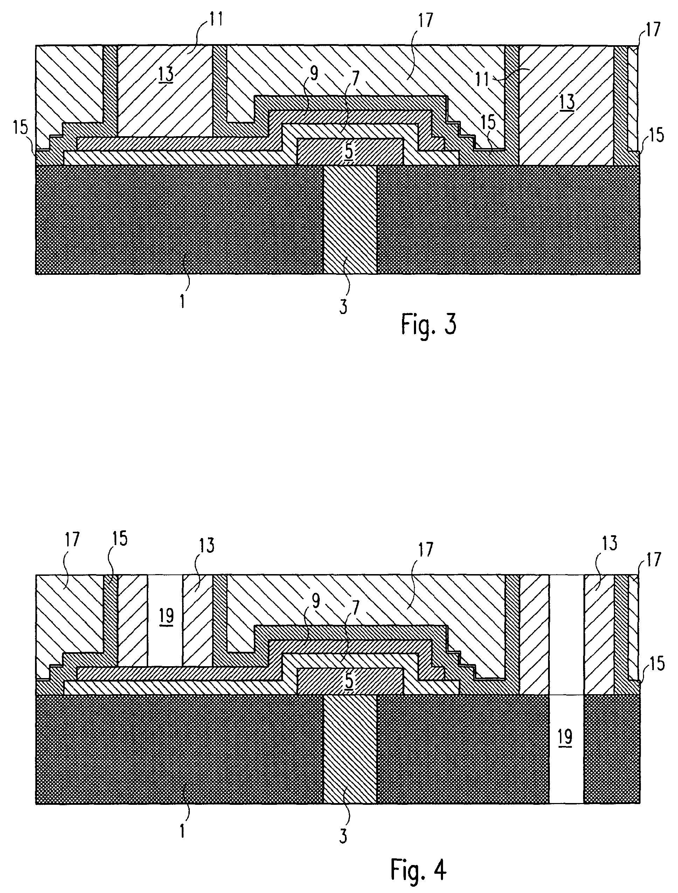

Mittels CMP(chemisch-mechanisches Polieren) wird nun Material des Gesamtaufbaus von oben abgetragen. Die Ätzebene verläuft dabei parallel zu der Oberflächenebene der Oxidschicht 17. Im Verlauf des Ätzvorganges wird zunächst ausschließlich Material der Oxidschicht 17 abgetragen, im weiteren Verlauf dann auch Material der Schutzschicht 15 in dem Bereich, wo die Schutzschicht 15 eine Art Deckel der links in Fig. 2 dargestellten Insel 11 bildet, und im weiteren Verlauf auch Material der links in Fig. 2 dargestellten Insel 11 und zusätzlich Material der Schutzschicht 15, wo die Schutzschicht 15 einen Deckel der rechts in Fig. 2 dargestellten Insel 11 bildet. Nachdem sowohl das Hilfsmaterial 13 der links dargestellten Insel 11 als auch der rechts dargestellten Insel 11 freigelegt ist kann der Ätzvorgang beendet werden. Das Ziel, die Erzeugung zweier fensterartiger Öffnungen in der Schutzschicht 15 ist dann erreicht (siehe Fig. 3).

Anschließend werden Kontaktlöcher 19 in das Hilfsmaterial 13 im Bereich der Restinseln eingebracht. Das in Fig. 4 links dargestellte Kontaktloch 19 erstreckt sich bis zur zweiten Elektrode 9. Das in Fig. 4 rechts dargestellte Kontaktloch 19 ist ein Durchgangsloch, das bis zur unteren Seite des Trägermaterials 1 vorangetrieben wird. Anschließend kann die elektrische Kontaktierung in bekannter Weise durch Auffüllen der Kontaktlöcher 19 und weitere Kontaktierung am unteren Ende des Durchgangslochs 19 vorgenommen werden.

Bei dem zuvor beschriebenen Ausführungsbeispiel ist das Material der zur öffnenden Schicht ein elektrisch isolierendes Material. Die Erfindung ist jedoch nicht auf solche Materialien beschränkt. Weist die zu öffnende Schicht ein elektrisch leitfähiges Material auf wird bei einer Variante des erfindungsgemäßen Verfahrens nach dem öffnen der Schicht bzw. nach dem Freilegen des Hilfsmaterials elektrisch isolierendes Material auf das verbliebene Material der zu öffnenden Schicht aufgebracht. Dies hat den Vorteil, dass eine unerwünschte elektrische Verbindung der zu öffnenden Schicht mit einer noch aufzubringenden oberflächlichen Metallisierungsschicht vermieden werden kann. Das elektrisch isolierende Material wird vorzugsweise als dünne zusätzliche Schicht aufgebracht. Eine derartige dünne Schicht stellt anders als das üblicherweise zum Auffüllen von tiefer gelegenen Bereichen verwendete Material kein Hindernis beim späteren ätzen von Kontaktlöchern dar. Vorzugsweise sind die Materialien der Hilfsstruktur und des auf das verbliebene Material der zu öffnenden Schicht aufgebrachte Isoliermaterial chemisch miteinander verwandt oder sind das gleiche Material. In diesem Fall kann beim Ätzen von Kontaktlöchern in einem durchgehenden Ätzschritt das jeweilige Loch in die zusätzlich Isolierschicht und in das Material der Hilfsstruktur hineingeätzt werden. Auch kann ein Ätzverfahren angewendet werden, dass eine hohe Selektivität aufweist, das heißt ein selektives Ätzen an der verwandten Materialien bzw. des einen Materials erlaubt.

Weiterhin ist das erfindungsgemäße Verfahren nicht auf das Aufbringen inselartiger Hilfsstrukturen beschränkt. Vielmehr ist es beispielsweise möglich, eine inselartige Hilfsstruktur, jedoch mit einer Ausnehmung in ihrem inneren oder zentralen Bereich aufzubringen. Eine solche Hilfsstruktur ist beispielsweise im Querschnitt ringförmig. Derartige Hilfsstrukturen können wie auch inselartige Hilfsstrukturen durch einen einzigen Lithographieschritt mit anschließendem wegätzen des überflüssigen Materials erzeugt werden.

Besteht eine derartige Hilfsstruktur aus elektrisch isolierendem Material und besteht die zu öffnende Schicht aus elektrisch leitfähigem Material, so entstehen nach dem öffnen der zu öffnenden Schicht zumindest zwei Bereiche mit elektrisch leitfähigem Material, die durch das Material der Hilfsstruktur elektrisch gegeneinander isoliert sind.
Die zuvor beschriebene Struktur, bei der zwei gegeneinander isolierte elektrisch leitfähige Bereiche der zu öffnenden Schicht vorhanden sind, ist dann besonders vorteilhaft, wenn die zu öffnende Schicht eine Wasserstoffbarriere darstellt ähnlich wie anhand der Figuren 1 bis 4 beschrieben. Hat die zu öffnende Schicht bzw. die durch das planare Ätzen bereits geöffnete Schicht elektrischen Kontakt mit einer Mehrzahl von Elektroden, wobei jeweils eine der Elektroden einem Kondensator zugeordnet ist, so muß ein Kurzschluß zwischen diesen Elektroden verhindert werden. Dies wird dadurch erreicht, dass jeweils einer der gegen andere Bereiche elektrisch isolierten Bereiche der elektrisch leitenden Wasserstoffbarriere nur mit einer der Elektroden elektrisch verbunden ist. Wenn jede der Elektroden mit einer elektrisch leitfähigen Wasserstoffbarriere verbunden ist, bedeutet dies, dass die Wasserstoffbarriere in entsprechender Weise elektrisch strukturiert ist wie die Elektroden der Kondensatoren in ihrer Gesamtheit.

Nach dem erfindungsgemäßen Vefahren kann daher zunächst eine oder mehrere Hilfsstrukturen aus elektrisch isolierendem Material aufgebracht werden, dann eine durchgehende elektrisch leitfähige Wasserstoffbarriere aufgebracht werden und durch planares Ätzen die Wasserstoffbarriere derart geöffnet werden, dass die gewünschte Struktur der Wasserstoffbarriere mit getrennten, gegeneinander isolierten Bereichen entsteht.

Das CMP hat gegenüber bekannten Verfahren zum Erzeugen von gezielten lokalen Öffnungen in einer Schicht den Vorteil, dass größere Ätzraten erreichbar sind. Weiterhin kann vorteilhafter Weise die auch ansonsten übliche Planarisierung der Oxidschicht 17 oder einer entsprechenden Schicht auf einem Halbleiterbauelement in einem einzigen Verfahrensschritt auch für die Öffnung der Schutzschicht 15 oder einer entsprechenden Schicht genutzt werden. Ferner lassen sich die Kontaktlöcher 19 in deutlichem Abstand zu der Schutzschicht 15 in das Hilfsmaterial 13 einbringen, so dass die Schutzschicht 15 außerhalb des geöffneten Bereichs völlig unbeschädigt bleibt. Insgesamt ist daher wie bei dem Ausführungsbeispiel gezeigt eine wirksame Barriere gegen das Eindringen unerwünschter Materialien wie beispielsweise Wasserstoff realisierbar. Auch ist die Prozeßführung sowohl beim CMP, als auch bei dem späteren Ätzen von Kontaktlöchern verhältnismäßig einfach, da beim Ätzen nicht genau gezielt werden muß, d.h. überhaupt keine Masken verwendet werden müssen (beim CMP) beziehungsweise für die Positionierung der Masken beim Ätzen der Kontaktlöcher ein verhältnismäßig großer Spielraum zur Verfügung steht. Es ist lediglich beim Strukturieren der Hilfsstrukturen, im Ausführungsbeispiel der Inseln 11, darauf zu achten, dass etwa die gewünschte Lage der späteren Kontaktlöcher festgelegt wird, und es ist darauf zu achten, dass die Hilfsstrukturen in ausreichendem Maß an ihren Flanken im Ausführungsbeispiel die in vertikaler Richtung verlaufenden Flanken, mit dem Material der Schutzschicht 15 bedeckt sind.

Die Schutzschicht 15 beziehungsweise eine entsprechende Schicht muß nicht unmittelbar auf die Hilfsstruktur aufgebracht werden, vielmehr können zunächst auf die Hilfsstruktur weitere Materialien aufgebracht werden beziehungsweise kann der Gesamtaufbau so gestaltet werden, dass zwischen dem Material der Hilfsstruktur und dem Material der zu öffnenden Schicht zumindest partiell weitere Materialien angeordnet sind.

## Patentansprüche

1. Verfahren zur gezielten lokalen Erzeugung von Öffnungen in einer Schicht (15), insbesondere einer Schutzschicht an mikroelektronischen Strukturen,
**dadurch gekennzeichnet, dass**
- auf ein Substrat (1, 5, 7, 9), gegebenenfalls mit daran befindlichen Strukturen, zumindest eine erhabene Hilfsstruktur (11) aus einem Hilfsmaterial (13) aufgebracht wird, so dass diese einen Teil der Oberfläche des Substrats (1, 5, 7 9) bedeckt,
- die zu öffnende Schicht (15) auf die Hilfsstruktur (11) aufgebracht wird, so dass sie einen zusammenhängenden Oberflächenbereich des Substrats (1, 5, 7, 9) und der Hilfsstruktur (11) bedeckt, und
- durch im wesentlichen planares Ätzen Material der Schicht (15) und gegebenenfalls weiteres an der Oberfläche liegendes Material (17) entfernt wird bis die Schicht (15) an der Hilfsstruktur (11) geöffnet wird und das Hilfsmaterial (13) freigelegt wird.

2. Verfahren nach Anspruch 1,
**dadurch gekennzeichnet, dass**
die erhabene Hilfsstruktur (11) eine inselartige Erhebung ist und dass das Material der Schicht (15) derart entfernt wird, dass es einen geschlossen umlaufenden Rand um das freigelegte Hilfsmaterial (13) bildet.

3. Verfahren nach Anspruch 1 oder 2,
**dadurch gekennzeichnet, dass**
nach dem Aufbringen der zu öffnenden Schicht (15) ein zweites Hilfsmaterial (17) aufgebracht wird.

4. Verfahren nach einem der Ansprüche 1 bis 3,
**dadurch gekennzeichnet, dass**
das planare Ätzen zumindest teilweise durch CMP (chemisch-mechanisches Polieren) ausgeführt wird.

5. Verfahren nach einem der Ansprüche 1 bis 4,
**dadurch gekennzeichnet, dass**
in das freiliegende Hilfsmaterial (13) der Hilfsstruktur (11) eine Ausnehmung (19) geätzt wird.

6. Verfahren nach Anspruch 5,
**dadurch gekennzeichnet, dass**
in die bis zu einem elektrisch leitfähigen Material reichende Ausnehmung (19) ein elektrisch leitfähiges Material eingebracht wird.

7. Verfahren nach einem der Ansprüche 1 bis 6,
**dadurch gekennzeichnet, dass**
das Substrat (1, 5, 7, 9) eine mikroelektronische Struktur (5, 7, 9) mit einem Kondensator aufweist, dessen Dielektrikum (7) ein ferroelektrisches oder paraelektrisches Material aufweist, und dass die zu öffnende Schicht (15) eine Barriere gegen Eindringen einer Substanz in die mikroelektronische Struktur (5, 7, 9) bildet.

8. Verfahren nach Anspruch 7,
**dadurch gekennzeichnet, dass**
das Dielektrikum (7) empfindlich gegen den Einfluß von Wasserstoff ist und das die zu öffnende Schicht (15) eine Barriere gegen ein Vordringen von Wasserstoff zu dem Dielektrikum (7) ist.

9. Verfahren nach einem der Ansprüche 1 bis 8, wobei die zu öffnende Schicht aus einem elektrisch leitenden Material besteht,
**dadurch gekennzeichnet, dass** nach dem Freilegen des Hilfsmaterials ein elektrisch isolierendes Material auf das verbliebene Material der zu öffnenden Schicht aufgebracht wird.
